# EUROPEAN PATENT SPECIFICATION

(11) **EP 4 187 600 B1**
(45) Date of publication and mention of the grant of the patent: **03.09.2025**
(21) Application number: 21210849.2
(22) Date of filing: 26.11.2021
(51) Int. Cl.: H01L 21/768, H01L 23/522, H01L 23/528, H01L 23/48, H01L 23/535, H10D 89/60

(54) **A SEMICONDUCTOR COMPONENT COMPRISING BACK SIDE I/O SIGNAL ROUTING**
HALBLEITERBAUELEMENT MIT RÜCKSEITEN-I/O-SIGNALFÜHRUNG
COMPOSANT À SEMI-CONDUCTEUR COMPRENANT UN ROUTAGE DE SIGNAUX D'ENTRÉE/SORTIE SUR LA FACE ARRIÈRE

(43) Date of publication of application: 31.05.2023
(73) Proprietor: Imec VZW, 3001 Leuven (BE)
(72) Inventor: Chen, Shih-Hung, 3010 Kessel-lo (BE); Beyne, Eric, 3001 Heverlee (BE); Van der Plas, Geert, 3000 Leuven (BE)
(74) Representative: Patent Department IMEC

(56) References cited:
- EP-B1- 3 324 436
- US-A1- 2021 242 130
- US-B2- 11 062 977
- US-B2- 9 214 390
- US-B2- 9 252 141

## Description

### Field of the Invention

The present invention is related to semiconductor processing, in particular to a semiconductor component, such as an integrated circuit chip, comprising active devices such as CMOS processed transistors at the front side of a semiconductor substrate, and wherein the I/O signal routing to and from the active devices takes places via the back side of the substrate.

### State of the art.

Back side power supply in integrated circuits has been part of an ongoing development in semiconductor processing, aimed at enabling increased device density in the front end of line. Higher numbers of active devices (mainly transistors) of ever decreasing device dimensions are placed on a given surface of semiconductor material. This has put a strain on the design and fabrication of the interconnects between these active devices and the power supply terminals of the IC.

A known solution to this problem has been the introduction of a power delivery network (PDN) on the back side of the semiconductor substrate, combined with the processing of buried power rails (BPR) in the front end of line, and Through Semiconductor Via (TSV) connections which are conductors which run from the front side of the substrate to the back side, connecting the power rails to the back side PDN and hence to power supply terminals also arranged on the back side of the chip. This solution is described for example in patent publication document EP3324436. Processing steps that may be implemented for the back side power supply include thinning the substrate on whose front side the active devices have been produced, to a thickness in the order of 1 micron or less, followed by the etching of nano-sized via openings, filling these openings with a conductive material, and producing interconnect layers on the back side of the thinned substrate. Alternative solutions are known by which the vias are formed prior to substrate thinning (so-called via-first approach). The via diameters are in the order of nanometers, hence the term 'nanoTSVs' which has been commonly used to describe these front-to-back connections.

The above-cited document also describes the routing of I/O signals to the back side of the chip, either through isolated portions of the PDN or through an area separate from the PDN. The I/O signals are thereby routed from the active devices at the front through nanoTSV connections to I/O terminals on the back side of the chip.

As nanoTSVs pass through a semiconductor substrate formed of a semiconductor material of a given polarity, the nanoTSVs that transmit I/O signals are required to be electrically isolated from that material. This is realized by providing a dielectric liner around the electrically conductive centre of the TSV.

However, the low thickness of this liner and its relatively large surface area are responsible for the creation of an important parasitic capacitance between the nanoTSV conductor and the surrounding substrate, which has a negative impact on functional signal transceiving. The parasitic capacitance of a back side I/O interconnect is in fact much larger than that of a front side I/O interconnect. Not only the nanoTSVs as such, but also the ESD protection devices in an external I/O design usually bring significant parasitic capacitance due to large device sizes.

Patent publication document EP3324436B1 is related to an integrated circuit comprising buried interconnects in the form of power and ground rails incorporated in the front end of line (FEOL). The power delivery network of the IC is located in its entirety on the backside of the chip. The PDN is connected to the buried interconnects through suitable connections, for example metal- filled vias of the type known as 'through-semiconductor vias' or 'through silicon vias' (TSV).

Patent publication document US9214390B2 discloses a through silicon via (TSV) surrounded by a dielectric liner. The TSV and dielectric liner are surrounded by a well region formed by thermal diffusion. The well region includes a dopant impurity type opposite the dopant impurity type of the substrate. The surrounding well region serves as an isolation well, reducing parasitic capacitance.

Patent publication document US22062977B2 discloses an integrated circuit in which a shield structure blocks the migration of charge to a semiconductor device from proximate a through substrate via (TSV). The shield structure comprises a p-n junction extending completely through the substrate and directly between the semiconductor device and the TSV.

### Summary of the invention

The invention aims to provide a solution to at least some of the above-described problems. This aim is achieved by a semiconductor component in accordance with the appended claims.

The invention is related to a semiconductor component, for example an integrated circuit chip, comprising a semiconductor substrate having active devices at the front side thereof and I/O terminals at the back side of the component. The I/O terminals are connected to the active devices through TSV connections and buried rails in an area of the substrate that is separate from the area in which the active devices are located. According to the invention, the I/O TSV connections are located in a floating well of the substrate that is separated from the rest of the substrate by a second well formed of material of the opposite conductivity type compared to the material of the floating well. The second well comprises at least one contact configured to be coupled to a voltage that is suitable for reverse-biasing the junction between the floating well and the second well. In this way, a small capacitance is placed in series with the large parasitic capacitance generated by a thin dielectric liner that isolates the I/O TSVs and I/O rails from the substrate, thereby mitigating the negative effect of the large parasitic capacitance. According to the invention, additional contacts and conductors are provided which are configured to create an ESD (Electrostatic Discharge) protection circuit for protecting the I/O TSVs and the I/O rails, and thereby the I/O terminals from electrostatic discharges.

The invention is in particular related to a semiconductor component comprising a semiconductor substrate having a front side and a back side, and comprising a first area and a second area not overlapping the first area, said areas extending from the front side of the substrate to the back side through the complete thickness of the substrate wherein the component comprises :
- a device layer at the front side of the substrate, comprising a plurality of active devices located in the first area, wherein said active devices are configured to receive input signals and to send output signals, said input and output signals being referred to hereafter by the common name 'I/O signals',
- a plurality of buried interconnect rails at least partially buried in the substrate, at the front side thereof, and located in the second area, said buried rails being referred to hereafter as 'I/O rails',
- a plurality of through substrate via (TSV) connections located in the second area, hereafter referred to as 'I/O TSVs', passing through the substrate from the buried rails to the back side of the substrate, each I/O TSV and each I/O rail being isolated from the substrate by a dielectric liner,
- a front side redistribution layer on the device layer, configured to route said I/O signals between the active devices in the first area and the buried I/O rails in the second area,
- input/output terminals at the back side of the component,
- a back side redistribution layer at the back side of the substrate configured to route said I/O signals between the I/O terminals on the back side of the component and the back end of the I/O TSVs,
- a plurality of power supply terminals (V_{SS},V_{DD}) and conductors connected thereto, configured to supply power to the active devices, the power supply terminals being coupled to either a reference voltage V_{SS} or a power voltage V_{DD},
and wherein :
- the plurality of I/O TSVs and the plurality of I/O rails are located in a first well of the substrate, said first well being formed of semiconductor material of a first conductivity type, said first well extending from the front side of the substrate to the back side of the substrate, through the complete thickness of the substrate,
- the first well is a floating well, i.e. a well that is not provided with contacts for applying a bias voltage to the first well,
- the substrate comprises a second well in the second area, the second well extending from the front side of the substrate to the back side of the substrate through the complete thickness of the substrate, wherein the second well separates the first well from the rest of the substrate, said second well being of a second conductivity type opposite the first conductivity type, so that a junction is formed between the first well and the second well,
- the second well includes at least one contact, configured to enable the application of a bias voltage to the second well, so as to reverse bias at least part of the junction between the first well and the second well.

According to an embodiment, the component further comprises buried power rails and power TSV connections in the first area, coupled to V_{SS} and V_{DD} terminals at the back side of the component and coupled to the active devices in said device layer at the front side of the substrate for supplying power thereto. Said contact of the second well may be coupled to V_{DD}.

The component of the invention further comprises additional contacts, junctions and conductors which implement an ESD protection circuit for protecting the I/O rails and the I/O TSVs from ESD pulses.

According to a first aspect of the invention :
- the substrate is formed of semiconductor material of the first conductivity type,
- said contact of the second well is coupled to V_{DD} and is hereafter referred to as the first contact, the first contact comprising a region of the second conductivity type,
- the substrate comprises a second contact coupled to V_{SS}, the second contact comprising a region of the first conductivity type, located adjacent the second well,
- the second well comprises a third contact opposite the first contact, meaning at the other side of the substrate compared to the first contact, the third contact comprising a region of the first conductivity type,
- the substrate comprises a fourth contact opposite the second contact, the fourth contact comprising a region of the second conductivity type,
- the third and fourth contacts are coupled to the I/O rails, so that the ESD circuit is a double diode circuit formed by two diodes formed respectively by at least part of the junction between the substrate and the region of the fourth contact and by at least part of the junction between the second well and the region of the third contact.

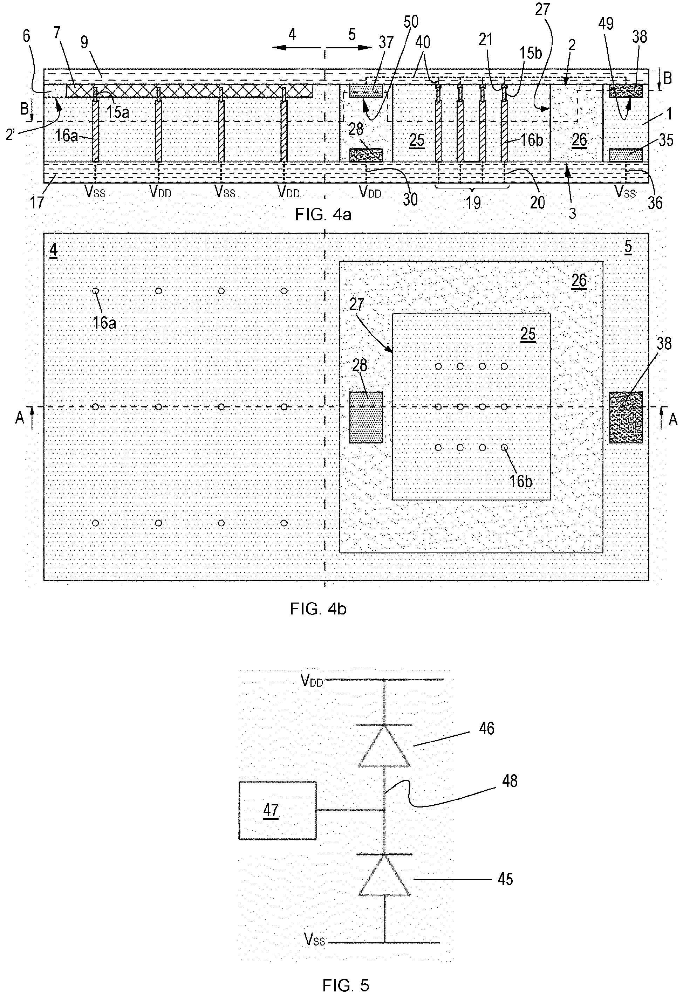

A double-diode circuit is an ESD protection circuit of an electronic component comprising one or more V_{SS} terminals, one or more V_{DD} terminals and one or more I/O terminals, the circuit comprising at least one set of two diodes as shown in Figure 5, i.e. two diodes coupled in series between V_{SS} and V_{DD}, and wherein the conductor that connects the diodes is coupled to the I/O terminals.

According to a further embodiment :
- the second well further comprises a fifth contact, comprising a region of the first conductivity type, and located adjacent the fourth contact and at the same side of the substrate as the fourth contact, wherein the fifth contact is coupled to the I/O rails, so that the ESD circuit additionally comprises a bipolar transistor formed by :
- at least part of the junction between the region of the fifth contact and the second well,
- at least part of the junction between the floating well and the second well.

According to a second aspect of the invention :
- the substrate is formed of semiconductor material of the first conductivity type,
- said contact of the second well is coupled to V_{DD} and is hereafter referred to as the first contact, the first contact comprising a region of the second conductivity type,
- the substrate comprises a second contact coupled to V_{SS}, the second contact comprising a region of the first conductivity type, located adjacent the second well,
- the second well comprises a third contact opposite the first contact, the third contact comprising a region of the first conductivity type,
- the second well comprises a fourth contact also opposite the first contact and adjacent the third contact, the fourth contact comprising a region of the second conductivity type,
- the second well comprises a fifth contact on the same side of the substrate as the third and fourth contacts but on the opposite side of the floating well, the fifth contact comprising a region of the second conductivity type,
- the substrate comprises a sixth contact adjacent the fifth contact and opposite the second contact, the sixth contact comprising a region of the second conductivity type,
- the substrate comprises a seventh contact adjacent the sixth contact and also opposite the second contact, the seventh contact comprising a region of the first conductivity type,
- the third contact and the sixth contact are coupled to the I/O rails,
- the fourth contact and the fifth contact are coupled to V_{DD},
- the seventh contact is coupled to V_{SS},
so that the ESD circuit is a double diode circuit comprising :
- a first set of two diodes formed respectively by a first portion of the junction between the substrate and the region of the sixth contact and by a first portion of the junction between the second well and the region of the third contact,
- a second set of two diodes formed respectively by a second portion of the junction between the substrate and the region of the sixth contact and by a second portion of the junction between the second well and the region of the third contact,
- a bipolar transistor formed by :
   ∘ At least part of the junction between the region of the sixth contact and the substrate,
   ∘ At least part of the junction between the floating well and the second well.

According to an embodiment, one or more of said additional contacts comprise regions which form guard rings around the floating well.

The invention is also related to a component according to any of the above embodiments, wherein the substrate is a p or n doped silicon substrate.

The invention is also related to an integrated circuit chip according to any of the above embodiments.

### Brief description of the figures

Figures 1a-1c show top section views and a front section view through a portion of an integrated circuit chip, comprising a floating p-well surrounded by an n-well.
Figures 2a and 2b show a top section view and a front section view through a portion of an integrated circuit chip comprising a floating p-well surrounded by an n-well.
Figures 3a and 3b show a top section view and a front section view through a portion of an integrated circuit wherein the n-well comprises a guard ring.
Figure 4a and 4b show a top section view and a front section view through a portion of an integrated circuit chip in accordance with an embodiment of the invention further comprising a ESD protection.
Figure 5 illustrates the equivalent circuit of the ESD protection of Figure 4.
Figures 6a and 6b show a further example of an integrated circuit chip according to the invention, comprising another embodiment of an ESD protection circuit.
Figure 7 illustrates the equivalent circuit of the ESD protection implemented in the embodiment of Figures 6a-6b.
Figures 8a and 8b show a further example of an integrated circuit chip according to the invention, comprising another embodiment of an ESD protection circuit.
Figure 9 illustrates the equivalent circuit of the ESD protection implemented in the embodiment of Figures 8a-8b.
Figures 10a and 10b illustrate an embodiment wherein the same ESD protection is implemented as in Figures 8a-8b, but wherein the various p+ and n+ regions at the front side are all implemented as guard rings.
Figures 11a and 11b illustrate an embodiment having supply power terminals at the front side and I/O terminals at the back side.

### Detailed description of the invention

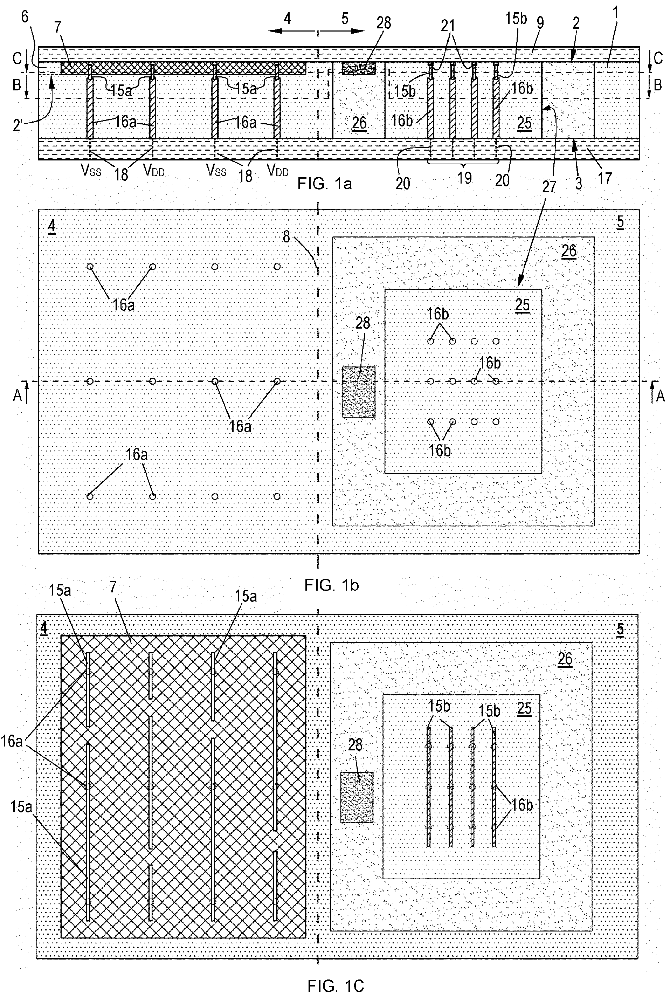

With reference to Figures 1a to 1c, a first embodiment of an integrated circuit is hereafter described. All cited materials and statements in relation to the dimensions of features shown in the drawings are merely given by way of example and not as limitations of the scope of the present invention. The figures are schematic simplifications of an actual IC and are aimed at explaining the characteristic elements of the invention. The figures are not intended to represent actual devices in terms of the relative position and dimensions of the various elements that are represented.

As seen in Figures 1a to 1c , the IC comprises a semiconductor substrate 1, which may be a monocrystalline Si substrate of a thickness between 200nm and 1 micrometer, having a front side and a back side, respectively indicated by the numerals 2 and 3. However, the terms 'front side' and 'back side' are not to be interpreted as unique planes of the substrate, but rather as more generic indicators of the distinction between the two planar sides of the substrate.

Throughout the present description and in the appended claims, the terms 'front side' and 'back side' are used in relation to the substrate as well as to the component (e.g. the IC) as a whole. When it is stated for example that a layer is located 'at the front side' of the substrate, this may refer to a layer that is on top of the substrate, possibly with other layers between the front surface of the substrate and the layer in question, or it may refer to a top layer of the substrate as such. Likewise, 'terminals' located 'at the back of the component' may include terminals directly on the back surface of the component or fully or partially embedded in said back surface. A dividing line 8 is drawn between a first area 4 and second area 5 of the substrate 1. The areas 4 and 5 are non-overlapping and extend from the front side 2 to the back side 3 of the substrate 1, through the full thickness of the substrate 1. At the front side of the substrate 1, the IC includes a device layer 6, comprising a plurality of active devices. The device layer 6 is a top layer of the substrate 1 as such, from the dotted line 2' upwards.

In modern day ICs the devices in layer 6 usually include a large number of nano-scaled transistors such as finFETs or nano-sheet based transistors, processed according to a given layout. Without showing details of the devices as such, the rectangle 7 in Figure 1 indicates a plurality of such devices located at the front side of the substrate 1, and in the first area 4. The second area 5 does not comprise active devices. The active device layer 6 further comprises electrical conductors (not shown) coupled to the active devices. These may include via connections to the source or drain and to the gate of finFET transistors. These connections are coupled to a front side redistribution layer 9 on top of the device layer 6, which is a layer comprising multiple levels of conductors running parallel to the substrate 1, with conductors of adjacent levels being interconnected by vertical via connections. These features are well known in the art and need not be described in more detail. The device layer 6, and in particular the rectangle 7 largely corresponds to the so-called front end of line (FEOL) portion of an IC, while the front side redistribution layer 9 largely corresponds to the back end of line portion (BEOL), with the multiple interconnect levels known as M1, M2 etc. The FEOL is often understood to comprise a first level of conductors directly coupled to the devices, the M0 (Metal zero) level. In the present context, this M0 level may be regarded either as part of the device layer 6 or as part of the front side redistribution layer 9.

With reference again to Figures 1a-1c, the IC further comprises interconnect rails 15a and 15b which are buried in the substrate 1. These rails are elongate structures which may for example be a few tens of nanometers in width, while extending longitudinally in the direction perpendicular to the frontal section view in Figure 1a. As indicated in the introduction, buried rails are well-known features enabling the supply of power to the active devices from the back side of the chip and/or to route I/O signals through the substrate 1.

In the first area 4 of the IC illustrated in Figure 1a, a first set of buried rails 15a is formed, which will hereafter be referred to as 'power rails'. An example of a possible pattern of the power rails 15a is illustrated in the section view along the plane C-C in Figure 1c. Details of the active devices are not shown in this view. As in the front section view of Figure 1a, the active devices are understood to be positioned in the rectangle 7. The power rails 15a extend through dielectric isolation areas (not shown) between adjacent active semiconductor portions, e.g. between groups of Si fins, and hence into the substrate 1. At the front side, the power rails 15a are connected to the active devices via local interconnects (not shown) which may include via connections and conductors in the M0 level. At the back side, the power rails 15a are connected to nanoTSVs 16a, hereafter referred to as 'power TSVs', which run through the full thickness of the substrate 1, to a back side redistribution layer 17. The position of the power TSVs 16a is also indicated in the plane section views of Figures 1b and 1c.

The back side redistribution layer 17 is similar to the front side redistribution layer 9, i.e. it is a multilevel interconnect structure comprising several layers of conductors running parallel to the substrate 1 and interconnected by via connections. The back side redistribution layer 17 together with the power TSVs 16a are part of the back side power delivery network PDN, configured to deliver power to the active devices in the first area (and other 'first areas' of the IC). Power supply voltage levels are conventionally noted as a power voltage V_{DD} supplied with respect to a reference (usually ground) voltage V_{SS}. Power terminals are provided at the back of the IC which are configured to be coupled to an external power source. In Figure 1a these terminals are indicated by the notations of V_{DD} and V_{SS} next to vertical dotted lines 18 passing from the power TSVs 16a to the back side of the IC. These dotted lines 18 do not represent actual conductors, but they are symbolic representations of the conductive paths, through conductors and vias of the back side redistribution layer 17, between the power TSVs 16a and the V_{DD} and V_{SS} terminals at the back side of the IC.

The second area 5 is now regarded in more detail. This second area 5 comprises an array of nanoTSVs 16b, hereafter referred to as 'I/O TSVs', dedicated to the transmission of I/O signals between the front side and the back side of the substrate 1. To this aim, the IC further comprises a number of I/O terminals 19 on its back side which are connected to the I/O TSVs 16b through conductors of the back side redistribution layer 17, symbolized by the dotted lines 20. The I/O TSVs 16b are connected at their front side to a further set of buried rails 15b, hereafter referred to as 'I/O rails', which are coupled to the front side redistribution layer 9 through conductors symbolized by the connections 21 which may be via connections or a combination of vias and conductors in the M0 level.

Through said front side redistribution layer 9, input and output signals are routed to and from the active devices in the first area 4. The I/O TSVs 16b and the I/O rails 15b and the connections 21 are isolated from the substrate 1 by dielectric liners, not shown in detail in the drawings because of the drawing scale, but well known in the art. This is a thin layer of a few nm thick, often formed of SiO₂, deposited on the sidewalls of via openings and trenches prior to filling these openings and trenches with an electrically conductive material such as Cu or Ru.

The elements described so far are known as such, i.e. I/O interconnects to the back side through 'I/O TSVs' and 'I/O buried rails' situated in an area that is remote from the active devices. As stated in the introduction, these configurations suffer from the high level of parasitic capacitance generated by the I/O TSVs and the I/O buried rails.

This problem is solved in the configuration shown in Figure 1, by the fact that the I/O TSVs 16b and I/O rails 15b are situated in a 'floating well' 25. This is a first well region 25 of the substrate, i.e. region of doped semiconductor material, 1 that extends from the front side of the substrate to the back side, across the full thickness of the substrate 1. The first well 25 consists of semiconductor material of a first conductivity type (p or n), and is separated from the rest of the substrate by a second well region 26 of the opposite conductivity type (n or p) extending also from the front side of the substrate to the back side across the full thickness of the substrate. For the sake of explaining the invention, the floating well 25 in the embodiment of Figure 1 will be described hereafter as a p-well 25, that is surrounded by an n-well 26. Also, the substrate 1 is to be regarded in the context of the following explanation as a p-doped substrate, i.e. the substrate 1 is p-doped everywhere except where n-doped regions are created. The inverse configuration with p and n reversed is however also possible.

The p-well 25 is 'floating' in the sense that it is not connected to an external voltage, i.e. it does not include a contact configured to be connected to such an external voltage. In particular, the p-well 25 is isolated from the V_{SS} and V_{DD} power terminals. On the other hand, the surrounding n-well 26 is configured to be biased, i.e. placed at a given voltage that can be set at a particular level, in order to cause the depletion of at least part of the p-n junction 27 between the floating well 25 and the surrounding n-well 26. In the embodiment shown, this is realized by producing a contact to the n-well 26 at the front side thereof, in the form of a heavily n-doped region 28 (hereafter referred to as 'n+ contact') that is connected to the lowest level of the front side redistribution layer 9. Said connection may take place by a via connection (not shown) between the contact 28 and said lowest level. The representation of a 'contact' as a heavily doped region is again a simplification of the reality in order to present merely the concept of the invention. In reality and as is known by the skilled reader, the contact comprises said heavily doped region as well as a contact pad on the heavily doped region, the pad formed of metal or another electrically conductive material.

Through the front side redistribution layer 9 and the n+ contact 28, the n-well 26 may then be placed at a required voltage, which could for example be the supply voltage V_{DD}, routed to the n+ contact 28 from a V_{DD} terminal (one of the locations labelled 'V_{DD}' in Figure 1a) at the back, through the power delivery network, the power TSVs 16a and power rails 15a, and the front side redistribution layer 9. Alternatively, the bias voltage may be another positive voltage, generated by one of the active devices and routed to the n+ contact 28 through the front side redistribution layer 9 to thereby reverse-bias at least part of the p-n junction 27.

The effect of the reverse-biased p-n junction 27 is to place a small capacitance in series with the large parasitic capacitance generated by the liners of the I/O TSVs 16b and the I/O rails 15b, resulting in a drastic reduction of the overall parasitic capacitance influencing the I/O signal transceiving through the I/O TSVs 16b and rails 15b.

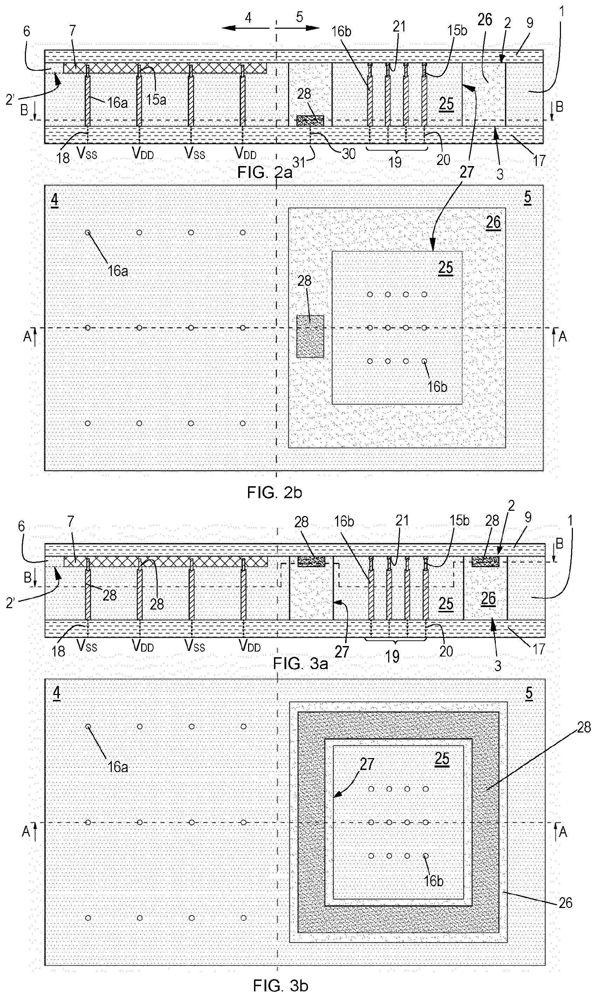

In an alternative embodiment that is equivalent to the embodiment of Figure 1, the bias voltage could be applied from the back side of the IC, as is illustrated in Figures 2a and 2b. The n+ contact 28 is now provided at the back surface of the substrate and coupled through conductors of the back side redistribution layer 17, symbolized by the dotted line 30, to a terminal 31 at the back of the IC. Terminal 31 could for example be coupled to the supply voltage V_{DD}.

The embodiment shown in Figures 3a and 3b has the same effect as the embodiment of Figures 1 and 2, but now the n+ region 28 is formed as a guard ring running along the complete upper surface of the n-well 26. This embodiment ensures that the depletion of the p-n junction 27 extends around the full circumference of the floating p-well 25.

According the invention, the means for creating a depleted p-n junction in series with the parasitic capacitance of the I/O rails 15b and I/O TSVs 16b is combined with additional contacts and connections which form an ESD protection circuit for the protection of the I/O terminals 19 and thereby the active devices in the first area 4 from electrostatic discharges. A first embodiment of this type is illustrated in Figures 4a and 4b. The n+ contact 28 is again a heavily n-doped region at the back side of the substrate (as in the embodiment of Figures 2a-2b), and connected to a V_{DD} terminal at the back side through conductors of the back side redistribution layer 17 symbolized by the dotted line 30. Adjacent to the n-well 26, the second area 5 of the substrate 1 now comprises a heavily p-doped region (hereafter referred to as p+ contact) 35 at the back side of the p-substrate 1, and a connection to this p+ contact 35 through conductors of the back side redistribution layer 17, symbolized by the dotted line 36, which are coupled to a V_{SS} terminal at the back side of the IC. At the front side of the substrate 1, a p+ contact 37 is provided in the n-well 26, opposite the contact 28, and an n+ contact 38 is provided in the p-substrate 1 adjacent the n-well 26 and opposite the contact 35. Both these additional p+ and n+ contacts 37 and 38 are connected through conductors of the front side redistribution layer 9 symbolized by the dotted lines 40 to all of the I/O rails 15b and I/O TSVs 16b. The doping type of regions 37 and 38 (p and n) is opposite to the doping type of the substrate parts 26 and 1 (n and p) in which they are embedded, thereby creating p-n junctions 50 and 49.

In this way, the well-known double diode ESD protection circuit is obtained, as depicted in Figure 5, comprising two diodes 45 and 46 arranged in series between V_{SS} and V_{DD}, and with the I/O interconnects 47 coupled to the connection 48 between the first and second diode. In the configuration of Figures 4a-4b, the junctions 49 and 50 respectively represent the diodes 45 and 46 of the ESD circuit. Only a portion of said junctions may actually contribute to the diode formation, depending on the exact geometry of the doped regions with respect to each other. It is therefore stated in the appended claims that the diodes are formed by 'at least part of the junctions'. The connection to V_{SS} is embodied by the p+ contact 35 and the path 36, while the connection to V_{DD} is embodied by the n+ contact 28 and the path 30. In this configuration, the junction 27 is reverse biased by the n-well 26 that is coupled to V_{DD} thereby decreasing the parasitic capacitance, while at the same time, the I/O interconnects (terminals 19, I/O TSVs 16b and I/O rails 15b) are protected from ESD pulses.

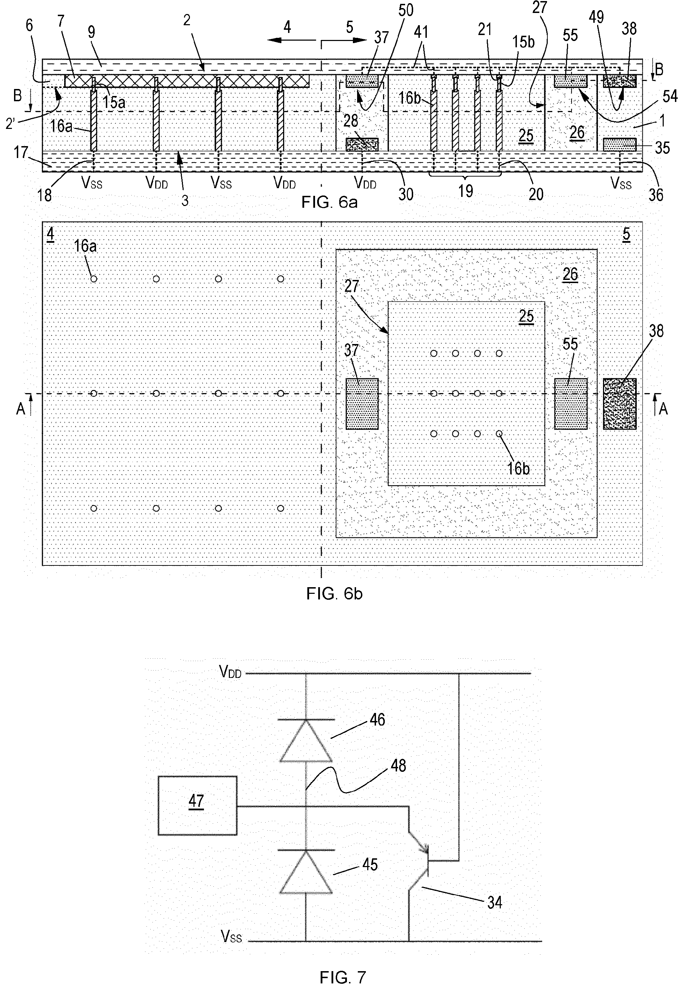

The integration of an ESD protection together with the decreased parasitic capacitance can be realized in various ways other than the configuration shown in Figures 4a-4b, as illustrated by a number of further embodiments. In the embodiment of Figures 6a-6b, an additional p+ contact 55 is implemented at the front side of the substrate 1, adjacent the n+ contact 38 and on the opposite side of the p-n junction 27 relative to said n+ contact 38. The additional p+ contact 55 is connected through conductors in the front side redistribution layer 9 symbolized by the dotted lines 41 to the I/O rails 15b and I/O TSVs 16b, i.e. this additional p+ region 55 is at the same voltage as the p+ contact 37 and the n+ contact 38. An additional p-n junction 54 is thereby created. The double diode circuit is therefore realized in the same manner as in the previous embodiment, but in addition thereto and as shown in the equivalent circuit in Figure 7, a parallel ESD discharge path is created between V_{SS} and V_{DD} by a bipolar pnp transistor 34 embodied by the junction 27 and at least a portion of junction 54.

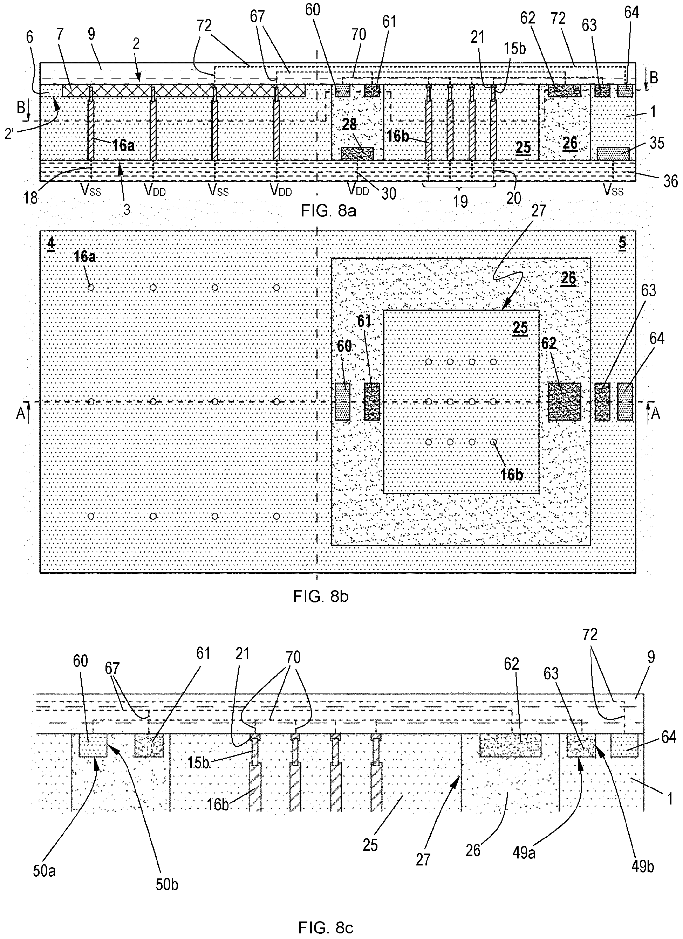

Another embodiment is shown in Figures 8a to 8c, with Figure 8c showing an enlarged detail of the front section shown in Figure 8a. The n+ contact 28 and the p+ contact 35 are again present at the back side of the substrate 1, respectively coupled to V_{DD} and V_{SS}. At the front side of the substrate, an n+ contact 60 and a p+ contact 61 are now provided in the n-well 26 on one side thereof and opposite the n+ contact 28, while another n+ contact 62 is provided also in the n-well 26 and at the front side of the substrate, but on the other side of the floating p-well 25 In the substrate adjacent to the n-well 26, another n+ contact 63 and a p+ contact 64 are provided. The n+ contacts 60 and 62 are both coupled to V_{DD}. The path that connects these front side n+ contacts 60 and 62 to a V_{DD} terminal at the back of the IC includes conductors of the front side redistribution layer 9, symbolized by the dotted lines 67. The p+ contact 61 and the n+ contact 63 are coupled to the I/O rails 15b and I/O TSVs 16b through conductors of the front side redistribution layer symbolized by the dotted lines 70. The p+ contact 64 is coupled to V_{SS}. The path that connects this front side p+ contact 64 to a V_{SS} terminal at the back of the IC includes conductors of the front side redistribution layer 9 symbolized by the dotted lines 72.

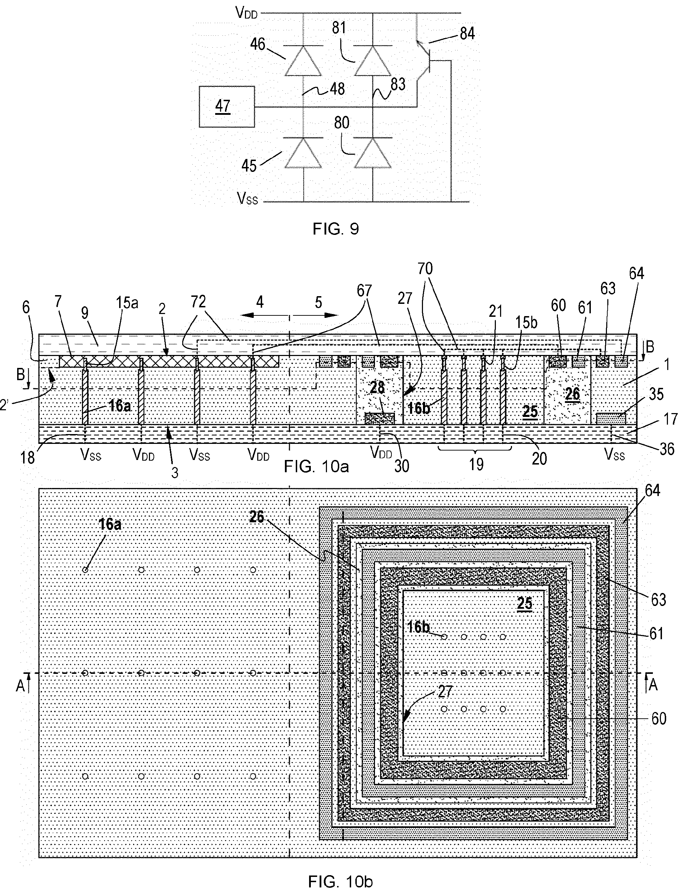

The equivalent circuit of the configuration of Figures 8a-8b is shown in Figure 9. The first diodes 45 and 46 are now embodied by portions 49a and 50a of the junctions 49 and 50 (see Fig. 8c). Two additional parallel diodes 80 and 81 coupled by connection 83 are embodied by the respective portions 49b and 50b of the junctions 49 and 50, while a parallel bipolar npn transistor 84 is embodied by the junctions 27 and a portion of junction 49.

Figures 10a and 10b show another embodiment, wherein the same ESD protection is implemented as in Figures 8 and 9, but wherein the various p+ and n+ regions of the various contacts at the front side of the substrate 1 form guard rings extending fully around the floating p-well 25. Regions 60 and 62 in Figure 8 are now part of the same guard ring 60. It is also possible to combine guard rings for some of the contacts with local regions for other contacts.

The embodiments shown in Figures 4 to 10 are mere examples of how an ESD circuit can be implemented together with the floating well configured to decrease the parasitic capacitance. Based on these examples, the skilled person is capable of devising other alternatives, which are therefore all included in the scope of the present invention.

In the embodiments of Figures 4 to 10, the n+ contact 28 and the p+ contact 35 are formed at the back side of the substrate, while the other contacts 37,38 etc are formed at the front side. The same ESD circuits can be obtained by reversing these positions, i.e. contacts 28 and 35 at the front side and the other contacts at the back side of the substrate. The routing of the various I/O signals and supply currents will be different, taking place through the front side redistribution layer 9 instead of the through the back side redistribution layer 17 or vice versa, but the eventual circuits will be the same.

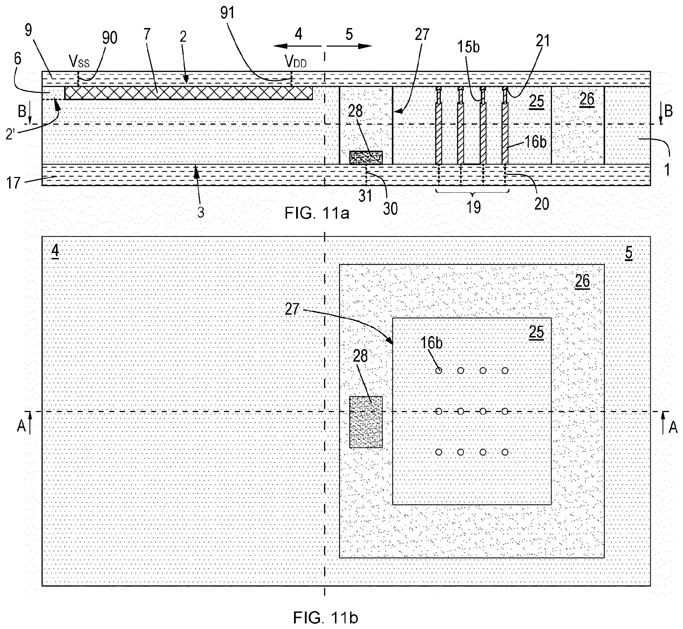

The disclosure is not limited to components having supply terminals for V_{SS} and V_{DD} on the back side, but it is also applicable to components having these supply terminals on the front side, while having I/O terminals on the back side. Such an embodiment is shown in Figures 11a and 11b, which is equivalent to Figure 1 apart from the location of the V_{DD} and V_{SS} terminals. These terminals are now at the front side and are configured to deliver power to the active devices in the first area 4 through conductors of the front side redistribution layer 9 symbolized by the dotted lines 90 and 91. Apart from this, the routing of the I/O signals through the back side and through I/O TSVs 16b located in a floating p-well 25 is the same as in the embodiment of Figure 1.

Methods that are applicable for producing a component according to the invention are well known to the skilled person and need not be described here in detail. Required method steps include dopant implant steps for creating the floating well 25 and/or the second well 26, as well as the doped regions of the various contacts 28, 35 etc. Suitable lithographic masks are to be applied in order to limit the dopant implants to the required areas.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A semiconductor component comprising a semiconductor substrate (1) having a front side (2) and a back side, and comprising a first area (4) and a second area (5) not overlapping the first area (4), said areas (4,5) extending from the front side (2) of the substrate (1) to the back side (3) through the complete thickness of the substrate (1) wherein the component comprises :
- a device layer (6) at the front side of the substrate (1), comprising a plurality of active devices (7) located in the first area (4), wherein said active devices are configured to receive input signals and to send output signals, said input and output signals being referred to hereafter by the common name 'I/O signals',
- a plurality of buried interconnect rails (15b) at least partially buried in the substrate (1), at the front side thereof, and located in the second area (5), said buried rails being referred to hereafter as 'I/O rails' (15b),
- a plurality of through substrate via (TSV) connections (16b) located in the second area (5), hereafter referred to as 'I/O TSVs', passing through the substrate (1) from the buried rails (15b) to the back side of the substrate (1), each I/O TSV (16b) and each I/O rail (15b) being isolated from the substrate by a dielectric liner,
- a front side redistribution layer (9) on the device layer (6), configured to route said I/O signals between the active devices in the first area (4) and the buried I/O rails (15b) in the second area (5),
- input/output terminals (19) at the back side of the component,
- a back side redistribution layer (17) at the back side of the substrate (1) configured to route said I/O signals between the I/O terminals (19) on the back side of the component and the back end of the I/O TSVs (16b),
- a plurality of power supply terminals (V_{SS},V_{DD}) and conductors (18) connected thereto, configured to supply power to the active devices, the power supply terminals being coupled to either a reference voltage V_{SS} or a power voltage V_{DD},
and wherein :
- the plurality of I/O TSVs (16b) and the plurality of I/O rails (15b) are located in a first well (25) of the substrate, said first well being formed of semiconductor material of a first conductivity type, said first well (25) extending from the front side (2) of the substrate (1) to the back side (3) of the substrate, through the complete thickness of the substrate (1)
- the first well (25) is a floating well, i.e. a well that is not provided with contacts for applying a bias voltage to the first well,
- the substrate (1) comprises a second well (26) in the second area (5), the second well (26) extending from the front side of the substrate (1) to the back side of the substrate through the complete thickness of the substrate (1), wherein the second well (26) separates the first well from the rest of the substrate, said second well being of a second conductivity type opposite the first conductivity type, so that a junction (27) is formed between the first well and the second well,
- the second well (26) includes at least one contact (28), configured to enable the application of a bias voltage to the second well, so as to reverse bias at least part of the junction (27) between the first well (25) and the second well (26),
**characterized in that** the component further comprises additional contacts, junctions and conductors which implement an ESD protection circuit for protecting the I/O rails (15b) and the I/O TSVs (16b) from ESD pulses, wherein :
- the substrate (1) is formed of semiconductor material of the first conductivity type,
- said contact (28) of the second well (26) is coupled to V_{DD} and is hereafter referred to as the first contact (28), the first contact comprising a region of the second conductivity type,
- the substrate (1) comprises a second contact (35) coupled to V_{SS}, the second contact comprising a region of the first conductivity type, located adjacent the second well (26),
- the second well (26) comprises a third contact (37) opposite the first contact (28), meaning at the other side of the substrate (1) compared to the first contact (28), the third contact comprising a region of the first conductivity type,
- the substrate (1) comprises a fourth contact (38) opposite the second contact (35), the fourth contact comprising a region of the second conductivity type,
- the third and fourth contacts (37,38) are coupled to the I/O rails (15b), so that the ESD circuit is a double diode circuit formed by two diodes (45,46) formed respectively by at least part of the junction (49) between the substrate (1) and the region of the fourth contact (38) and by at least part of the junction (50) between the second well (26) and the region of the third contact (37).

2. The component according to claim 1, wherein the second well (26) further comprises a fifth contact (55), comprising a region of the first conductivity type, and located adjacent the fourth contact (38) and at the same side of the substrate (1) as the fourth contact (38), wherein the fifth contact is coupled to the I/O rails (15b), so that the ESD circuit additionally comprises a bipolar transistor (34) formed by :
- at least part of the junction (54) between the region of the fifth contact (55) and the second well (26),
- at least part of the junction (27) between the floating well (25) and the second well (26).

3. A semiconductor component comprising a semiconductor substrate (1) having a front side (2) and a back side, and comprising a first area (4) and a second area (5) not overlapping the first area (4), said areas (4,5) extending from the front side (2) of the substrate (1) to the back side (3) through the complete thickness of the substrate (1) wherein the component comprises :
- a device layer (6) at the front side of the substrate (1), comprising a plurality of active devices (7) located in the first area (4), wherein said active devices are configured to receive input signals and to send output signals, said input and output signals being referred to hereafter by the common name 'I/O signals',
- a plurality of buried interconnect rails (15b) at least partially buried in the substrate (1), at the front side thereof, and located in the second area (5), said buried rails being referred to hereafter as 'I/O rails' (15b),
- a plurality of through substrate via (TSV) connections (16b) located in the second area (5), hereafter referred to as 'I/O TSVs', passing through the substrate (1) from the buried rails (15b) to the back side of the substrate (1), each I/O TSV (16b) and each I/O rail (15b) being isolated from the substrate by a dielectric liner,
- a front side redistribution layer (9) on the device layer (6), configured to route said I/O signals between the active devices in the first area (4) and the buried I/O rails (15b) in the second area (5),
- input/output terminals (19) at the back side of the component,
- a back side redistribution layer (17) at the back side of the substrate (1) configured to route said I/O signals between the I/O terminals (19) on the back side of the component and the back end of the I/O TSVs (16b),
- a plurality of power supply terminals (V_{SS},V_{DD}) and conductors (18) connected thereto, configured to supply power to the active devices, the power supply terminals being coupled to either a reference voltage V_{SS} or a power voltage V_{DD},
and wherein :
- the plurality of I/O TSVs (16b) and the plurality of I/O rails (15b) are located in a first well (25) of the substrate, said first well being formed of semiconductor material of a first conductivity type, said first well (25) extending from the front side (2) of the substrate (1) to the back side (3) of the substrate, through the complete thickness of the substrate (1)
- the first well (25) is a floating well, i.e. a well that is not provided with contacts for applying a bias voltage to the first well,
- the substrate (1) comprises a second well (26) in the second area (5), the second well (26) extending from the front side of the substrate (1) to the back side of the substrate through the complete thickness of the substrate (1), wherein the second well (26) separates the first well from the rest of the substrate, said second well being of a second conductivity type opposite the first conductivity type, so that a junction (27) is formed between the first well and the second well,
- the second well (26) includes at least one contact (28), configured to enable the application of a bias voltage to the second well, so as to reverse bias at least part of the junction (27) between the first well (25) and the second well (26),
**characterized in that** the component further comprises additional contacts, junctions and conductors which implement an ESD protection circuit for protecting the I/O rails (15b) and the I/O TSVs (16b) from ESD pulses, wherein:
- the substrate (1) is formed of semiconductor material of the first conductivity type,
- said contact (28) of the second well (26) is coupled to V_{DD} and is hereafter referred to as the first contact (28), the first contact comprising a region of the second conductivity type,
- the substrate (1) comprises a second contact (35) coupled to V_{SS}, the second contact comprising a region of the first conductivity type, located adjacent the second well (26),
- the second well (26) comprises a third contact (60) opposite the first contact (28), the third contact (60) comprising a region of the first conductivity type,
- the second well (26) comprises a fourth contact (61) also opposite the first contact (28) and adjacent the third contact (60), the fourth contact (61) comprising a region of the second conductivity type,
- the second well (26) comprises a fifth contact (62) on the same side of the substrate (1) as the third and fourth contacts (60,61) but on the opposite side of the floating well (25), the fifth contact (62) comprising a region of the second conductivity type,
- the substrate (1) comprises a sixth contact (63) adjacent the fifth contact (62) and opposite the second contact (35), the sixth contact (63) comprising a region of the second conductivity type,
- the substrate (1) comprises a seventh contact (64) adjacent the sixth contact (3) and also opposite the second contact (35), the seventh contact (64) comprising a region of the first conductivity type,
- the third contact (60) and the sixth contact (63) are coupled to the I/O rails (15b),
- the fourth contact (61) and the fifth contact (62) are coupled to V_{DD},
- the seventh contact (64) is coupled to V_{SS},
so that the ESD circuit is a double diode circuit comprising :
- a first set of two diodes (45,46) formed respectively by a first portion (49a) of the junction between the substrate (1) and the region of the sixth contact (63) and by a first portion (50a) of the junction between the second well (26) and the region of the third contact (60),
- a second set of two diodes (80,81) formed respectively by a second portion (49b) of the junction between the substrate (1) and the region of the sixth contact (63) and by a second portion (50b) of the junction between the second well (26) and the region of the third contact (60),
- a bipolar transistor (84) formed by :
∘ At least part of the junction (49) between the region of the sixth contact (63) and the substrate (1),
∘ At least part of the junction (27) between the floating well (25) and the second well (26).

4. The component according to any one of the preceding claims, further comprising buried power rails (15a) and power TSV connections (16a) in the first area (4), coupled to V_{SS} and V_{DD} terminals at the back side of the component and coupled to the active devices in said device layer (6) at the front side of the substrate for supplying power thereto.

5. The component according to any one of the preceding claims, wherein said contact (28) of the second well (26) is coupled to V_{DD}.

6. The component according to any one of the preceding claims, wherein one or more of said additional contacts comprise regions which form guard rings around the floating well.

7. The component according to any one of the preceding claims, wherein the substrate (1) is a p or n doped silicon substrate.

8. The component according to any one of the preceding claims, wherein said component is an integrated circuit chip.

## Patentansprüche

1. Halbleiterbauelement, das ein Halbleitersubstrat (1) umfasst, das eine Vorderseite (2) und eine Rückseite aufweist, und einen ersten Bereich (4) und einen zweiten Bereich (5) umfasst, der den ersten Bereich (4) nicht überlappt, wobei sich die Bereiche (4,5) von der Vorderseite (2) des Substrats (1) durch die gesamte Dicke des Substrats (1) hindurch zur Rückseite (3) erstrecken, wobei das Bauelement umfasst:
- eine Vorrichtungsschicht (6) an der Vorderseite des Substrats (1), die eine Vielzahl von aktiven Vorrichtungen (7) umfasst, die sich im ersten Bereich (4) befinden, wobei die aktiven Vorrichtungen konfiguriert sind, um Eingangssignale zu empfangen und Ausgangssignale zu senden, wobei die Eingangs- und Ausgangssignale nachstehend mit dem gemeinsamen Namen "E/A-Signale" bezeichnet werden,
- eine Vielzahl von verborgenen Verbindungsschienen (15b), die mindestens teilweise im Substrat (1) an der Vorderseite davon verborgen sind und sich im zweiten Bereich (5) befinden, wobei die verborgenen Schienen nachstehend als "E/A-Schienen" (15b) bezeichnet werden,
- eine Vielzahl von Substrat-Durchkontaktierungs- (TSV-) Verbindungen (16b), die sich im zweiten Bereich (5) befinden, nachstehend als "E/A-TSVs" bezeichnet, die von den verborgenen Schienen (15b) durch das Substrat (1) hindurch zur Rückseite des Substrats (1) verlaufen, wobei jede E/A-TSV (16b) und jede E/A-Schiene (15b) durch eine dielektrische Auskleidung vom Substrat isoliert ist,
- eine Vorderseiten-Umverdrahtungsschicht (9) auf der Vorrichtungsschicht (6), die konfiguriert ist, um die E/A-Signale zwischen den aktiven Vorrichtungen im ersten Bereich (4) und den verborgenen E/A-Schienen (15b) im zweiten Bereich (5) zu routen,
- Eingangs/Ausgangs-Anschlüsse (19) an der Rückseite des Bauelements,
- eine Rückseiten-Umverdrahtungsschicht (17) an der Rückseite des Substrats (1), die konfiguriert ist, um die E/A-Signale zwischen den E/A-Anschlüssen (19) auf der Rückseite des Bauelements und dem hinteren Ende der E/A-TSVs (16b) zu routen,
- eine Vielzahl von Stromversorgungsanschlüssen (V_{SS}, V_{DD}) und damit verbundenen Leitern (18), die konfiguriert sind, um die aktiven Vorrichtungen mit Strom zu versorgen, wobei die Stromversorgungsanschlüsse entweder an eine Referenzspannung V_{SS} oder eine Stromspannung V_{DD} gekoppelt sind, und wobei:
- die Vielzahl von E/A-TSVs (16b) und die Vielzahl von E/A-Schienen (15b) sich in einer ersten Wanne (25) des Substrats befinden, wobei die erste Wanne aus Halbleitermaterial eines ersten Leitfähigkeitstyps gebildet ist, wobei sich die erste Wanne (25) von der Vorderseite (2) des Substrats (1) durch die gesamte Dicke des Substrats (1) hindurch zur Rückseite (3) des Substrats erstreckt,
- die erste Wanne (25) eine schwebende Wanne ist, d. h. eine Wanne, die nicht mit Kontakten zum Anlegen einer Vorspannung an die erste Wanne bereitgestellt ist,
- das Substrat (1) im zweiten Bereich (5) eine zweite Wanne (26) umfasst, wobei sich die zweite Wanne (26) von der Vorderseite des Substrats (1) durch die gesamte Dicke des Substrats (1) hindurch zur Rückseite des Substrats erstreckt, wobei die zweite Wanne (26) die erste Wanne vom Rest des Substrats trennt, wobei die zweite Wanne von einem zweiten Leitfähigkeitstyp ist, der dem ersten Leitfähigkeitstyp gegenüberliegt, sodass zwischen der ersten Wanne und der zweiten Wanne ein Übergang (27) gebildet wird,
- die zweite Wanne (26) mindestens einen Kontakt (28) beinhaltet, der konfiguriert ist, um das Anlegen einer Vorspannung an die zweite Wanne zu ermöglichen, um mindestens einen Teil des Übergangs (27) zwischen der ersten Wanne (25) und der zweiten Wanne (26) in Sperrrichtung vorzuspannen,
**dadurch gekennzeichnet, dass** das Bauelement weiter zusätzliche Kontakte, Übergänge und Leiter umfasst, die eine ESD-Schutzschaltung zum Schützen der E/A-Schienen (15b) und der E/A-TSVs (16b) vor ESD-Impulsen implementieren, wobei:
- das Substrat (1) aus Halbleitermaterial vom ersten Leitfähigkeitstyp gebildet ist,
- der Kontakt (28) der zweiten Wanne (26) an VDD gekoppelt ist und nachstehend als der erste Kontakt (28) bezeichnet wird, wobei der erste Kontakt eine Region vom zweiten Leitfähigkeitstyp umfasst,
- das Substrat (1) einen zweiten Kontakt (35) umfasst, der an V_{SS} gekoppelt ist, wobei der zweite Kontakt eine Region vom ersten Leitfähigkeitstyp umfasst, die sich an die zweite Wanne (26) angrenzend befindet,
- die zweite Wanne (26) einen dritten Kontakt (37) umfasst, der dem ersten Kontakt (28) gegenüber, das heißt auf der anderen Seite des Substrats (1) im Vergleich zum ersten Kontakt (28) liegt, wobei der dritte Kontakt eine Region vom ersten Leitfähigkeitstyp umfasst,
- das Substrat (1) einen vierten Kontakt (38) umfasst, der dem zweiten Kontakt (35) gegenüberliegt, wobei der vierte Kontakt eine Region vom zweiten Leitfähigkeitstyp umfasst,
- der dritte und vierte Kontakt (37, 38) mit den E/A-Schienen (15b) gekoppelt sind, sodass die ESD-Schaltung eine Doppeldiodenschaltung ist, die von zwei Dioden (45,46) gebildet wird, die jeweils von mindestens einem Teil des Übergangs (49) zwischen dem Substrat (1) und der Region des vierten Kontakts (38) und von mindestens einem Teil des Übergangs (50) zwischen der zweiten Wanne (26) und der Region des dritten Kontakts (37) gebildet werden.

2. Bauelement nach Anspruch 1, wobei die zweite Wanne (26) weiter einen fünften Kontakt (55) umfasst, der eine Region vom ersten Leitfähigkeitstyp umfasst und sich an den vierten Kontakt (38) angrenzend, und auf der gleichen Seite des Substrats (1) wie der vierte Kontakt (38) befindet, wobei der fünfte Kontakt mit den E/A-Schienen (15b) gekoppelt ist, sodass die ESD-Schaltung zusätzlich einen Bipolartransistor (34) umfasst, der gebildet wird durch:
- mindestens einen Teil des Übergangs (54) zwischen der Region des fünften Kontakts (55) und der zweiten Wanne (26),
- mindestens einen Teil des Übergangs (27) zwischen der schwebenden Wanne (25) und der zweiten Wanne (26).

3. Halbleiterbauelement, das ein Halbleitersubstrat (1) umfasst, das eine Vorderseite (2) und eine Rückseite aufweist, und einen ersten Bereich (4) und einen zweiten Bereich (5) umfasst, der den ersten Bereich (4) nicht überlappt, wobei sich die Bereiche (4,5) von der Vorderseite (2) des Substrats (1) durch die gesamte Dicke des Substrats (1) hindurch zur Rückseite (3) erstrecken, wobei das Bauelement umfasst:
- eine Vorrichtungsschicht (6) an der Vorderseite des Substrats (1), die eine Vielzahl von aktiven Vorrichtungen (7) umfasst, die sich im ersten Bereich (4) befinden, wobei die aktiven Vorrichtungen konfiguriert sind, um Eingangssignale zu empfangen und Ausgangssignale zu senden, wobei die Eingangs- und Ausgangssignale nachstehend mit dem gemeinsamen Namen "E/A-Signale" bezeichnet werden,
- eine Vielzahl von verborgenen Verbindungsschienen (15b), die mindestens teilweise im Substrat (1) an der Vorderseite davon verborgen sind und sich im zweiten Bereich (5) befinden, wobei die verborgenen Schienen nachstehend als "E/A-Schienen" (15b) bezeichnet werden,
- eine Vielzahl von Substrat-Durchkontaktierungs- (TSV-) Verbindungen (16b), die sich im zweiten Bereich (5) befinden, nachstehend als "E/A-TSVs" bezeichnet, die von den verborgenen Schienen (15b) durch das Substrat (1) hindurch zur Rückseite des Substrats (1) verlaufen, wobei jede E/A-TSV (16b) und jede E/A-Schiene (15b) durch eine dielektrische Auskleidung vom Substrat isoliert ist,
- eine Vorderseiten-Umverdrahtungsschicht (9) auf der Vorrichtungsschicht (6), die konfiguriert ist, um die E/A-Signale zwischen den aktiven Vorrichtungen im ersten Bereich (4) und den verborgenen E/A-Schienen (15b) im zweiten Bereich (5) zu routen,
- Eingangs/Ausgangs-Anschlüsse (19) an der Rückseite des Bauelements,
- eine Rückseiten-Umverdrahtungsschicht (17) an der Rückseite des Substrats (1), die konfiguriert ist, um die E/A-Signale zwischen den E/A-Anschlüssen (19) auf der Rückseite des Bauelements und dem hinteren Ende der E/A-TSVs (16b) zu routen,
- eine Vielzahl von Stromversorgungsanschlüssen (V_{SS}, V_{DD}) und damit verbundenen Leitern (18), die konfiguriert sind, um die aktiven Vorrichtungen mit Strom zu versorgen, wobei die Stromversorgungsanschlüsse entweder an eine Referenzspannung V_{SS} oder eine Stromspannung V_{DD} gekoppelt sind,
und wobei:
- die Vielzahl von E/A-TSVs (16b) und die Vielzahl von E/A-Schienen (15b) sich in einer ersten Wanne (25) des Substrats befinden, wobei die erste Wanne aus Halbleitermaterial eines ersten Leitfähigkeitstyps gebildet ist, wobei sich die erste Wanne (25) von der Vorderseite (2) des Substrats (1) durch die gesamte Dicke des Substrats (1) hindurch zur Rückseite (3) des Substrats erstreckt,
- die erste Wanne (25) eine schwebende Wanne ist, d. h. eine Wanne, die nicht mit Kontakten zum Anlegen einer Vorspannung an die erste Wanne bereitgestellt ist,
- das Substrat (1) im zweiten Bereich (5) eine zweite Wanne (26) umfasst, wobei sich die zweite Wanne (26) von der Vorderseite des Substrats (1) durch die gesamte Dicke des Substrats (1) hindurch zur Rückseite des Substrats erstreckt, wobei die zweite Wanne (26) die erste Wanne vom Rest des Substrats trennt, wobei die zweite Wanne von einem zweiten Leitfähigkeitstyp ist, der dem ersten Leitfähigkeitstyp gegenüberliegt, sodass zwischen der ersten Wanne und der zweiten Wanne ein Übergang (27) gebildet wird,
- die zweite Wanne (26) mindestens einen Kontakt (28) beinhaltet, der konfiguriert ist, um das Anlegen einer Vorspannung an die zweite Wanne zu ermöglichen, um mindestens einen Teil des Übergangs (27) zwischen der ersten Wanne (25) und der zweiten Wanne (26) in Sperrrichtung vorzuspannen,
**dadurch gekennzeichnet, dass** das Bauelement weiter zusätzliche Kontakte, Übergänge und Leiter umfasst, die eine ESD-Schutzschaltung zum Schützen der E/A-Schienen (15b) und der E/A-TSVs (16b) vor ESD-Impulsen implementieren, wobei:
- das Substrat (1) aus Halbleitermaterial vom ersten Leitfähigkeitstyp gebildet ist,
- der Kontakt (28) der zweiten Wanne (26) an V_{DD} gekoppelt ist und nachstehend als der erste Kontakt (28) bezeichnet wird, wobei der erste Kontakt eine Region vom zweiten Leitfähigkeitstyp umfasst,
- das Substrat (1) einen zweiten Kontakt (35) umfasst, der an V_{SS} gekoppelt ist, wobei der zweite Kontakt eine Region vom ersten Leitfähigkeitstyp umfasst, die sich an die zweite Wanne (26) angrenzend befindet,
- die zweite Wanne (26) einen dritten Kontakt (60) umfasst, der dem ersten Kontakt (28) gegenüberliegt, wobei der dritte Kontakt (60) eine Region vom ersten Leitfähigkeitstyp umfasst,
- die zweite Wanne (26) einen vierten Kontakt (61) umfasst, der ebenfalls dem ersten Kontakt (28) gegenüberliegt und an den dritten Kontakt (60) angrenzt, wobei der vierte Kontakt (61) eine Region vom zweiten Leitfähigkeitstyp umfasst,
- die zweite Wanne (26) einen fünften Kontakt (62) auf der gleichen Seite des Substrats (1) wie der dritte und der vierte Kontakt (60,61), aber auf der der schwebenden Wanne (25) gegenüberliegenden Seite umfasst, wobei der fünfte Kontakt (62) eine Region vom zweiten Leitfähigkeitstyp umfasst,
- das Substrat (1) einen sechsten Kontakt (63) umfasst, der an den fünften Kontakt (62) angrenzt und dem zweiten Kontakt (35) gegenüberliegt, wobei der sechste Kontakt (63) eine Region vom zweiten Leitfähigkeitstyp umfasst,
- das Substrat (1) einen siebten Kontakt (64) umfasst, der an den sechsten Kontakt (3) angrenzt und ebenfalls dem zweiten Kontakt (35) gegenüberliegt, wobei der siebte Kontakt (64) eine Region vom ersten Leitfähigkeitstyp umfasst,
- der dritte Kontakt (60) und der sechste Kontakt (63) mit dem E/A-Schienen (15b) gekoppelt sind,
- der vierte Kontakt (61) und der fünfte Kontakt (62) an V_{DD} gekoppelt sind,
- der siebte Kontakt (64) an V_{SS} gekoppelt ist, sodass die ESD-Schaltung eine Doppeldiodenschaltung ist, umfassend:
- einen ersten Satz aus zwei Dioden (45,46), die jeweils durch einen ersten Abschnitt (49a) des Übergangs zwischen dem Substrat (1) und der Region des sechsten Kontakts (63) und durch einen ersten Abschnitt (50a) des Übergangs zwischen der zweiten Wanne (26) und der Region des dritten Kontakts (60) gebildet werden,
- einen zweiten Satz aus zwei Dioden (80,81), die jeweils durch einen zweiten Abschnitt (49b) des Übergangs zwischen dem Substrat (1) und der Region des sechsten Kontakts (63) und durch einen zweiten Abschnitt (50b) des Übergangs zwischen der zweiten Wanne (26) und der Region des dritten Kontakts (60) gebildet werden,
- einen Bipolartransistor (84), der gebildet wird durch:
- mindestens einen Teil des Übergangs (49) zwischen der Region des sechsten Kontakts (63) und dem Substrat (1),
- Mindestens einen Teil des Übergangs (27) zwischen der schwebenden Wanne (25) und der zweiten Wanne (26).

4. Bauelement nach einem der vorstehenden Ansprüche, das weiter verborgene Stromschienen (15a) und TSV-Stromverbindungen (16a) im ersten Bereich (4) umfasst, die an V_{SS}- und V_{DD}-Anschlüsse auf der Rückseite des Bauelements gekoppelt sind und an die aktiven Vorrichtungen in der Vorrichtungsschicht (6) an der Vorderseite des Substrats gekoppelt sind, um diese mit Strom zu versorgen.

5. Bauelement nach einem der vorstehenden Ansprüche, wobei der Kontakt (28) der zweiten Wanne (26) an V_{DD} gekoppelt ist.

6. Bauelement nach einem der vorstehenden Ansprüche, wobei einer oder mehrere der zusätzlichen Kontakte Regionen umfassen, die Schutzringe um die schwebende Wanne bilden.

7. Bauelement nach einem der vorstehenden Ansprüche, wobei das Substrat (1) ein p- oder n-dotiertes Siliziumsubstrat ist.

8. Bauelement nach einem der vorstehenden Ansprüche, wobei das Bauelement ein integrierter Schaltungschip ist.

## Revendications

1. Composant semi-conducteur comprenant un substrat semi-conducteur (1) présentant une face avant (2) et une face arrière, et comprenant une première zone (4) et une seconde zone (5) ne chevauchant pas la première zone (4), lesdites zones (4, 5) s'étendant de la face avant (2) du substrat (1) à la face arrière (3) sur toute l'épaisseur du substrat (1), dans lequel le composant comprend :
- une couche de dispositif (6) sur la face avant du substrat (1), comprenant une pluralité de dispositifs actifs (7) situés dans la première zone (4), dans lequel lesdits dispositifs actifs sont configurés pour recevoir des signaux d'entrée et pour envoyer des signaux de sortie, lesdits signaux d'entrée et de sortie étant désignés ci-après par le nom commun « signaux E/S »,
- une pluralité de rails d'interconnexion enterrés (15b) au moins partiellement enterrés dans le substrat (1), sur sa face avant, et situés dans la seconde zone (5), lesdits rails enterrés étant ci-après désignés par « rails E/S » (15b),
- une pluralité de connexions traversantes de substrat (TSV) (16b) situées dans la seconde zone (5), ci-après désignées par « TSV E/S », traversant le substrat (1) depuis les rails enterrés (15b) jusqu'à la face arrière du substrat (1), chaque TSV E/S (16b) et chaque rail E/S (15b) étant isolés du substrat par un revêtement diélectrique,
- une couche de redistribution côté avant (9) sur la couche de dispositif (6), configurée pour acheminer ledit signal E/S entre les dispositifs actifs dans la première zone (4) et les rails E/S enterrés (15b) dans la seconde zone (5),
- des bornes entrée/sortie (19) sur la face arrière du composant,
- une couche de redistribution côté arrière (17) sur la face arrière du substrat (1) configurée pour acheminer lesdits signaux E/S entre les bornes E/S (19) sur la face arrière du composant et à l'extrémité arrière du TSV E/S (16b),
- une pluralité de bornes d'alimentation (V_{SS}, V_{DD}) et de conducteurs (18) connectés à celles-ci, configurés pour alimenter les dispositifs actifs, les bornes d'alimentation étant couplées soit à une tension de référence V_{SS} soit à une tension d'alimentation V_{DD}, et dans lequel :
- la pluralité de TSV E/S (16b) et la pluralité de rails E/S (15b) sont situés dans un premier puits (25) du substrat, ledit premier puits étant formé d'un matériau semi-conducteur d'un premier type de conductivité, ledit premier puits (25) s'étendant de la face avant (2) du substrat (1) à la face arrière (3) du substrat, sur toute l'épaisseur du substrat (1)
- le premier puits (25) est un puits flottant, c'est-à-dire un puits qui n'est pas pourvu de contacts pour appliquer une tension de polarisation au premier puits,
- le substrat (1) comprend un second puits (26) dans la seconde zone (5), le second puits (26) s'étendant de la face avant du substrat (1) à la face arrière du substrat sur toute l'épaisseur du substrat (1), dans lequel le second puits (26) sépare le premier puits du reste du substrat, ledit second puits étant d'un second type de conductivité opposé au premier type de conductivité de sorte qu'une jonction (27) soit formée entre le premier puits et le second puits,
- le second puits (26) inclut au moins un contact (28) configuré pour permettre l'application d'une tension de polarisation au second puits de manière à inverser une partie de la jonction (27) entre le premier puits (25) et le second puits (26),
**caractérisé en ce que** le composant comprend en outre des contacts, des jonctions et des conducteurs supplémentaires qui mettent en œuvre un circuit de protection ESD pour protéger les rails E/S (15b) et le TSV E/S (16b) provenant d'impulsions ESD, dans lequel :
- le substrat (1) est formé d'un matériau semi-conducteur du premier type de conductivité,
- ledit contact (28) du second puits (26) est couplé à V_{DD} et est ci-après désigné par le premier contact (28), le premier contact comprenant une région du second type de conductivité,
- le substrat (1) comprend un deuxième contact (35) couplé à V_{SS}, le deuxième contact comprenant une région du premier type de conductivité, située à proximité du second puits (26),
- le second puits (26) comprend un troisième contact (37) opposé au premier contact (28), c'est-à-dire de l'autre côté du substrat (1) par rapport au premier contact (28), le troisième contact comprenant une région du premier type de conductivité,
- le substrat (1) comprend un quatrième contact (38) opposé au deuxième contact (35), le quatrième contact comprenant une région du second type de conductivité,
- les troisième et quatrième contacts (37,38) sont couplés aux rails E/S (15b) de sorte que le circuit ESD soit un circuit à double diode formé de deux diodes (45,46) formées respectivement par au moins une partie de la jonction (49) entre le substrat (1) et la région du quatrième contact (38) et par au moins une partie de la jonction (50) entre le second puits (26) et la région du troisième contact (37).

2. Composant selon la revendication 1, dans lequel le second puits (26) comprend en outre un cinquième contact (55), comprenant une région du premier type de conductivité, et situé à proximité du quatrième contact (38) et du même côté du substrat (1) que le quatrième contact (38), dans lequel le cinquième contact est couplé aux rails I/O (15b) de sorte que le circuit ESD comprenne en outre un transistor bipolaire (34) formé par :
- au moins une partie de la jonction (54) entre la région du cinquième contact (55) et le second puits (26),
- au moins une partie de la jonction (27) entre le puits flottant (25) et le second puits (26).

3. Composant semi-conducteur comprenant un substrat semi-conducteur (1) présentant une face avant (2) et une face arrière, et comprenant une première zone (4) et une seconde zone (5) ne chevauchant pas la première zone (4), lesdites zones (4, 5) s'étendant de la face avant (2) du substrat (1) à la face arrière (3) sur toute l'épaisseur du substrat (1), dans lequel le composant comprend :
- une couche de dispositif (6) sur la face avant du substrat (1), comprenant une pluralité de dispositifs actifs (7) situés dans la première zone (4), dans lequel lesdits dispositifs actifs sont configurés pour recevoir des signaux d'entrée et pour envoyer des signaux de sortie, lesdits signaux d'entrée et de sortie étant désignés ci-après par le nom commun « signaux E/S »,
- une pluralité de rails d'interconnexion enterrés (15b) au moins partiellement enterrés dans le substrat (1), sur sa face avant, et situés dans la seconde zone (5), lesdits rails enterrés étant ci-après dénommés « rails E/S » (15b),
- une pluralité de connexions traversantes de substrat (TSV) (16b) situées dans la seconde zone (5), ci-après dénommées « TSV E/S », traversant le substrat (1) depuis les rails enterrés (15b) jusqu'à la face arrière du substrat (1), chaque TSV E/S (16b) et chaque rail E/S (15b) étant isolés du substrat par un revêtement diélectrique,
- une couche de redistribution côté avant (9) sur la couche de dispositif (6), configurée pour acheminer lesdits signaux E/S entre les dispositifs actifs dans la première zone (4) et les rails E/S enterrés (15b) dans la seconde zone (5),
- des bornes entrée/sortie (19) sur la face arrière du composant,
- une couche de redistribution côté arrière (17) sur la face arrière du substrat (1) configurée pour acheminer lesdits signaux E/S entre les bornes E/S (19) sur la face arrière du composant et à l'extrémité arrière du TSV E/S (16b),
- une pluralité de bornes d'alimentation (V_{SS}, V_{DD}) et de conducteurs (18) connectés à celles-ci, configurés pour alimenter les dispositifs actifs, les bornes d'alimentation étant couplées soit à une tension de référence V_{SS} soit à une tension d'alimentation V_{DD},
et dans lequel :
- la pluralité de TSV E/S (16b) et la pluralité de rails E/S (15b) sont situés dans un premier puits (25) du substrat, ledit premier puits étant formé d'un matériau semi-conducteur d'un premier type de conductivité, ledit premier puits (25) s'étendant de la face avant (2) du substrat (1) à la face arrière (3) du substrat, sur toute l'épaisseur du substrat (1)
- le premier puits (25) est un puits flottant, c'est-à-dire un puits qui n'est pas pourvu de contacts pour appliquer une tension de polarisation au premier puits,
- le substrat (1) comprend un second puits (26) dans la seconde zone (5), le second puits (26) s'étendant de la face avant du substrat (1) à la face arrière du substrat sur toute l'épaisseur du substrat (1), dans lequel le second puits (26) sépare le premier puits du reste du substrat, ledit second puits étant d'un second type de conductivité opposé au premier type de conductivité de sorte qu'une jonction (27) soit formée entre le premier puits et le second puits,
- le second puits (26) inclut au moins un contact (28), configuré pour permettre l'application d'une tension de polarisation au second puits de manière à inverser une partie de la jonction (27) entre le premier puits (25) et le second puits (26),
**caractérisé en ce que** le composant comprend en outre des contacts, des jonctions et des conducteurs supplémentaires qui mettent en œuvre un circuit de protection ESD pour protéger les rails E/S (15b) et le TSV E/S (16b) provenant d'impulsions ESD, dans lequel :
- le substrat (1) est formé d'un matériau semi-conducteur du premier type de conductivité,
- ledit contact (28) du second puits (26) est couplé à V_{DD} et est ci-après désigné par le premier contact (28), le premier contact comprenant une région du second type de conductivité,
- le substrat (1) comprend un deuxième contact (35) couplé à V_{SS}, le deuxième contact comprenant une région du premier type de conductivité, située à proximité du second puits (26),
- le second puits (26) comprend un troisième contact (60) opposé au premier contact (28), le troisième contact (60) comprenant une région du premier type de conductivité,
- le second puits (26) comprend un quatrième contact (61) également opposé au premier contact (28) et adjacent au troisième contact (60), le quatrième contact (61) comprenant une région du second type de conductivité,
- le second puits (26) comprend un cinquième contact (62) sur le même côté du substrat (1) que les troisième et quatrième contacts (60,61) mais sur le côté opposé du puits flottant (25), le cinquième contact (62) comprenant une région du second type de conductivité,
- le substrat (1) comprend un sixième contact (63) adjacent au cinquième contact (62) et opposé au deuxième contact (35), le sixième contact (63) comprenant une région du second type de conductivité,
- le substrat (1) comprend un septième contact (64) adjacent au sixième contact (3) et également opposé au deuxième contact (35), le septième contact (64) comprenant une région du premier type de conductivité,
- le troisième contact (60) et le sixième contact (63) sont couplés aux rails E/S (15b),
- le quatrième contact (61) et le cinquième contact (62) sont couplés à V_{DD},
- le septième contact (64) est couplé à V_{SS} de sorte que le circuit ESD soit un circuit à double diode comprenant :
- un premier ensemble de deux diodes (45,46) formé respectivement par une première portion (49a) de la jonction entre le substrat (1) et la région du sixième contact (63) et par une première portion (50a) de la jonction entre le second puits (26) et la région du troisième contact (60),
- un second ensemble de deux diodes (80, 81) formé respectivement par une seconde portion (49b) de la jonction entre le substrat (1) et la région du sixième contact (63) et par une seconde portion (50b) de la jonction entre le second puits (26) et la région du troisième contact (60),
- un transistor bipolaire (84) formé par :∘
∘au moins une partie de la jonction (49) entre la région du sixième contact (63) et le substrat (1),
∘au moins une partie de la jonction (27) entre le puits flottant (25) et le second puits (26).

4. Composant selon l'une quelconque des revendications précédentes, comprenant en outre des rails d'alimentation enterrés (15a) et des connexions TSV d'alimentation (16a) dans la première zone (4), couplées à des bornes V_{SS} et V_{DD} sur la face arrière du composant et couplées aux dispositifs actifs dans ladite couche de dispositif (6) sur la face avant du substrat pour leur fournir de l'énergie.

5. Composant selon l'une quelconque des revendications précédentes, dans lequel ledit contact (28) du second puits (26) est couplé à V_{DD}.

6. Composant selon l'une quelconque des revendications précédentes, dans lequel un ou plusieurs desdits contacts supplémentaires comprennent des régions qui forment des anneaux de garde autour du puits flottant.

7. Composant selon l'une quelconque des revendications précédentes, dans lequel le substrat (1) est un substrat de silicium dopé p ou n.

8. Composant selon l'une quelconque des revendications précédentes, dans lequel ledit composant est une puce de circuit intégré.
